## Europäisches Patentamt
## European Patent Office
## Office européen des brevets

(19)

(11) Veröffentlichungsnummer: **0 217 104**
**B1**

(12)

# EUROPÄISCHE PATENTSCHRIFT

(45) Veröffentlichungstag der Patentschrift:
27.06.90

(21) Anmeldenummer: 86111590.5

(22) Anmeldetag: 21.08.86

(51) Int. Cl.⁵: **H03M 7/22**

(54) Integrierbare Dekodierschaltung.

(30) Priorität: 20.09.85 DE 3533606

(43) Veröffentlichungstag der Anmeldung:
08.04.87 Patentblatt 87/15

(45) Bekanntmachung des Hinweises auf die Patenterteilung:
27.06.90 Patentblatt 90/26

(84) Benannte Vertragsstaaten:
AT DE FR GB IT NL

(56) Entgegenhaltungen:
EP-A- 0 061 513
GB-A- 2 144 563
US-A- 3 397 325
US-A- 3 539 823
US-A- 4 176 287

IBM TECHNICAL DISCLOSURE BULLETIN, Band 15,
Nr. 9, Februar 1973, Seiten 2823,2824, New York, US; R.
KENYON et al.: "Complementary field effect transistor
high-density decoder"

(73) Patentinhaber: Siemens Aktiengesellschaft,
Wittelsbacherplatz 2, D-8000 München 2(DE)

(72) Erfinder: Fuchs, Hans Peter, Dipl.-Phys.,
Mitterhoferstrasse 19, D-8000 München 21(DE)
Erfinder: Goetz, Jürgen R., Dr. Dipl.-Phys., Finkenweg 3,
D-8059 Oberneuching(DE)

## Beschreibung

Die Erfindung betrifft eine integrierbare Dekodierschaltung zum Dekodieren einer durch Eingangssignale dargestellten Information. Handelt es sich bei der dargestellten Information z.B. um Adressen eines Halbleiterspeichers, so wird eine gattungsgemäße Dekodierschaltung auch als Adreßdekoder bezeichnet. Bei der dargestellten Information kann es sich jedoch auch um Daten handeln, die bei einem Assoziativspeicher einerseits zur Adreßermittlung dienen und andererseits Bestandteil der abzuspeichernden oder auszulesenden Daten sind. Des weiteren kann es sich um Informationen handeln, die bestimmen, welche Teile beispielsweise einer Maschine oder Anlage (in Abhängigkeit von diesen Informationen) betrieben werden sollen oder nicht, oder die bestimmen, wie solche Maschinenteile oder die Anlage betrieben werden sollen. Der mögliche Verwendungszweck für eine gattungsgemäße Dekodierschaltung ist also sehr vielfältig.

Bei integrierten Halbleiterspeichern werden beispielsweise für jede Wortleitung eine als Adreßdekoder bezeichnete gattungsgemäße Dekodierschaltung verwendet. Weist ein solcher Halbleiterspeicher z.B. 2$^p$ Wortleitungen auf, so sind zu deren Ansteuerung entsprechend 2$^p$ Adreßdekoder notwendig, die alle parallel von p Eingangssignalen bzw. dazu komplementären Signalen angesteuert werden. Entsprechendes gilt für die Bitleitungen, sofern diese nicht zu sogenannten Halb- oder Ganzworten adreßmäßig zusammengeschaltet sind.

Aus der DE-A-26 41 693 ist eine gattungsgemäße Dekodierschaltung bekannt, aufgeteilt in einen Dekodierkreis und eine Ausgangsstufe. Die eigentliche Dekodierung erfolgt dabei im Dekodierkreis. Dieser weist einen Lasttransistor auf, der zwischen die Versorgungsspannung und den Dekodierkreisausgang geschaltet ist. Er weist des weiteren p parallelgeschaltete Transistoren auf, die zwischen den Dekodierkreisausgang und ein weiteres Versorgungspotential, das üblicherweise die Bezugsspannung (Masse) darstellt, geschaltet sind. Am Gate des Lasttransistors liegt ein Taktsignal. An den Gates per p parallelgeschalteten Transistoren liegen jeweils eines der p verschiedenen Eingangssignale (Adreßsignale) oder eines der dazu komplementären Adreßsignale. Im Betrieb werden in jedem Speicherzyklus zunächst die Dekodierkreisausgänge aller Adreßdekoder über ihre durch das Taktsignal gesteuerte Lasttransistoren auf die Versorgungsspannung aufgeladen, gegebenenfalls vermindert um deren Schwellspannung.

Die Adreßsignale des Adreßdekoders, der ausgewählt werden soll, weisen anschließend alle einen der Bezugsspannung entsprechenden Pegel auf (logisch "0"). Damit bleibt der Dekodierkreisausgang des ausgewählten Adreßdekoders schwebend auf seinem zuvor aufgeladenen Potential. Wegen dabei auftretender Leckströme läßt sich dieser Zustand jedoch nur einer begrenzte Zeit beibehalten. Bei allen anderen Adreßdekodern nimmt mindestens eines der anliegenden Adreßsignale den der Versorgungsspannung entsprechenden Pegel (logisch "1") an, womit der zugeordnete Dekodierkreisausgang auf die Bezugsspannrung entladen wird.

Zusammenfassend läßt sich also folgendes über den bekannten Adreßdekoder aussagen: An jeden einzelnen Adreßdekoder sind alle p Adreßsignale (oder deren dazu komplementäre Signale) angeschlossen. Dies ergibt eine enorme Leitungslänge für die Adreßsignale mit allen daraus resultieren den Nachteilen, z.B. einer immensen kapazitiven Belastung dieser Leitungen. Daraus resultiert dann die Forderung, den Adreßdekodern vorgeschaltete Adreßpuffer und -treiber besonders groß und leistungsfähig dimensionieren zu müssen und insbesondere auf hohe Spitzenströme auslegen zu müssen (die Adreßsignale schalten alle gleichzeitig). Dadurch, daß in jedem Speicherzyklus die Ausgänge aller 2$^p$ Adreßdekoder auf die Versorgungsspannung aufgeladen werden, und dadurch, daß anschließend alle Dekodierkreisausgänge mit Ausnahme dessen des ausgewählten Adreßdekoders wieder auf die Bezugsspannung entladen werden, wird enorm viel Strom, und damit Leistung, verbraucht, wobei der Strom wiederum als Spitzenstrom verbraucht wird. Bei einer gegebenenfalls notwendigen Verkürzung der Speicherzykluszeit (Verkürzung der Speicherzugriffszeit) steigt der obengenannte Stromverbrauch exponentiell mit der Verkürzung an.

Aus US-A 3 539 823 ist ein CMOS-Logikgatter bekannt nach Art zweier in Bezug zueinander stehender NOR-Gatter. Im n-MOS-Teil des Logikgatters steuern Eingangssignale und dazu komplementäre Eingangssignale n-Kanal-Transistoren an, die hierarchisch nach Art eines Baumes angeordnet sind. Im p-MOS-Teil des Logikgatters ist für ein erstes der Eingangssignale (sowie für dessen dazu komplementäres Eingangssignal) ein p-Kanal-Transistor vorgesehen, der zusammen mit einem entsprechenden n-Kanal-Transistor des n-MOS-Teils einen CMOS-Inverter bildet. Die p-Kanal-Transistoren für die restlichen Eingangssignale sind jedoch andersartig angeordnet.

Aus US-A 4 176 287 ist ein CMOS-Dekoder bekannt. Die n-Kanal-Transistoren sind mit Adreßsignalen und dazu komplementären Adreßsignalen verbunden. Die p-Kanal-Transistoren sind reine Lasttransistoren bezüglich der Dekoderausgänge.

Aufgabe der vorliegenden Erfindung ist es, eine gattungsgemäße integrierbare Dekodierschaltung zu schaffen, die weniger Strom, insbesondere Spitzenstrom verbraucht, die insgesamt geringere Leitungslängen für die Eingangssignale benötigt (bezogen auf alle benötigten Dekodierschaltungen einer funktionellen Einheit, z.B. eines Halbleiterspeichers) und bei der die Dekoderausgänge zu keinem Zeitpunkt potentialmäßig frei schweben, wie oben beschrieben, sondern die immer gezielt auf einem der Versorgungspotentiale, gegebenenfalls verändert um den Betrag einer Transistorschwellspannung, gehalten werden.

Diese Aufgabe wird gelöst durch die Merkmale des Patentanspruches 1.

Vorteilhafte Fortbildungen und Ausgestaltungen sind in Unteransprüchen gekennzeichnet.

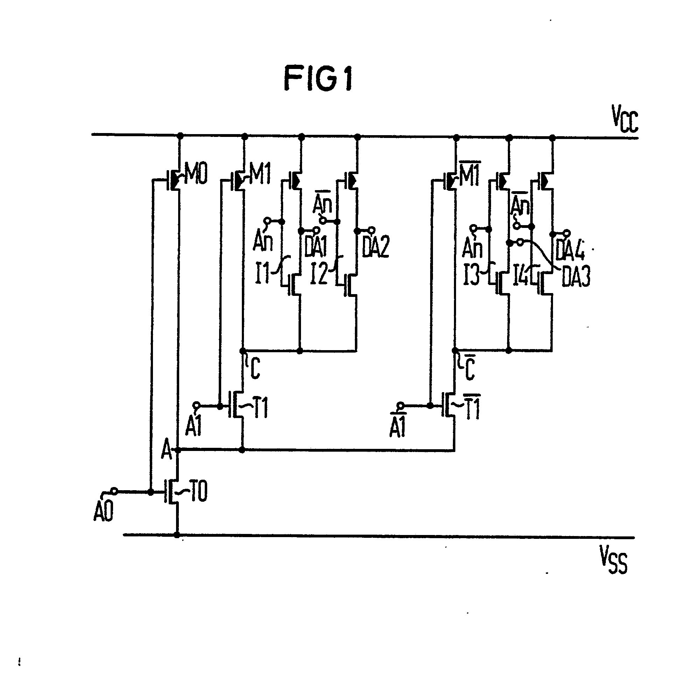

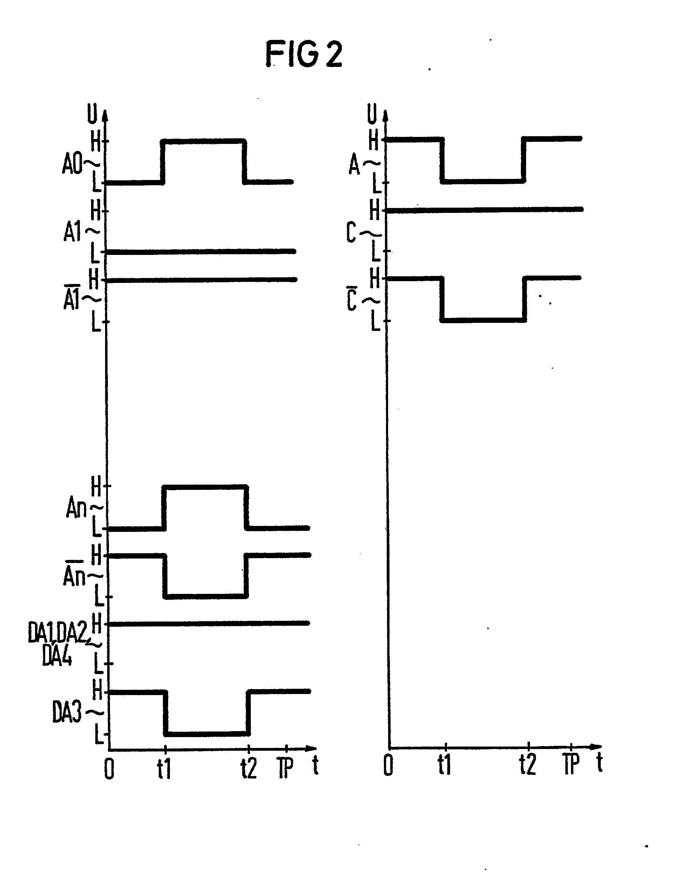

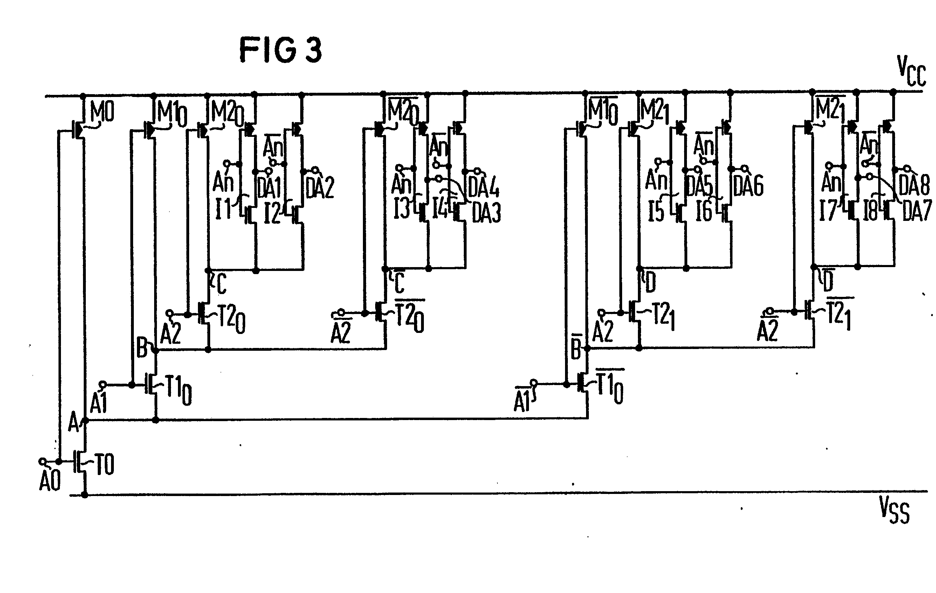

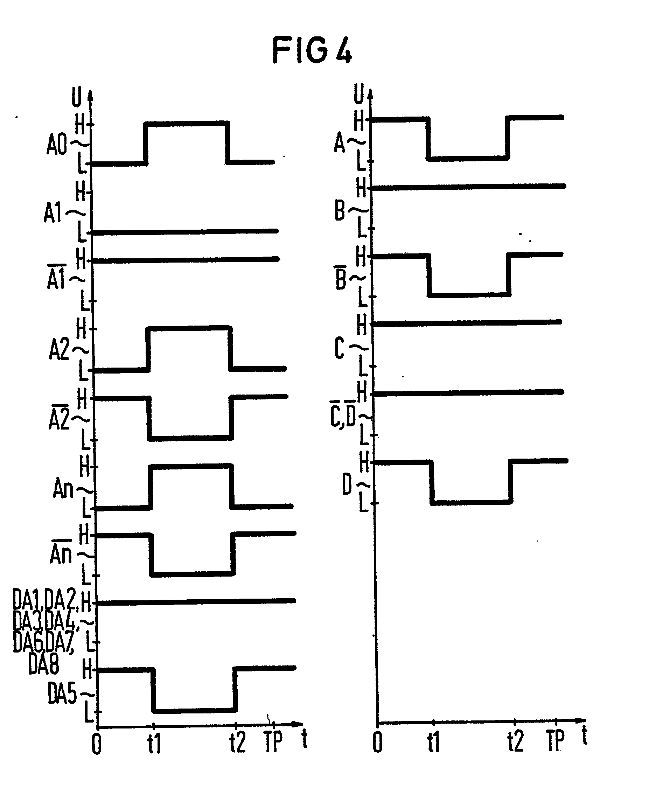

Nachstehend wird die Erfindung anhand der Figuren 1 und 3, die vorteilhafte Ausgestaltungen zeigen, sowie den Figuren 2 und 4, die zugehörige Zeitdiagramme zeigen, näher erläutert. Figur 1 zeigt eine erste Ausführungsform der erfindungsgemäßen Dekodierschaltung. Sie weist Eingänge für ein einzelnes Eingangssignal AO und für vier weitere, paarweise zueinander komplementäre Eingangssignale A1,An, $\overline{A1}$, $\overline{An}$ sowie vier Dekoderausgänge DA1 bis DA4 auf. Die gesamte Dekodierschaltung ist erfindungsgemäß in CMOS-Technologie aufgebaut. Dies hat gegenüber herkömmlichen Technologien wie z.B. n-Kanal-Technologie viele Vorteile, u.a. einen um Faktoren geringeren Stromverbrauch und das Wegfallen von Taktsignalen und Generatoren zu deren Erzeugung. Insbesondere für Dekodierschaltungen in Halbleiterspeichern bietet sich die CMOS-Technologie auch deshalb an, weil viele moderne Halbleiterspeichertypen wie z.B. IMBit-DRAM's, von Hause aus in CMOS-Technologie entwickelt und gefertigt werden.

Die vorteilhafte Dekodierschaltung nach Figur 1 enthält des weiteren vier übliche CMOS-Inverter I1 bis I4, deren Ausgänge jeweils gleichzeitig einen Dekoderausgang DA1 bis DA4 bilden. Bei jedem CMOS-Inverter I1 bis I4 ist die Source des Transistors vom einen Kanaltyp mit einem ersten Versorgungspotential VCC verbunden. Dieses erste Versorgungspotential VCC kann z.B. 5 V betragen, was einen typischen Wert darstellt bei CMOS-Technologie. Bei jeweils zwei der vier CMOS-Inverter I1 bis I4, z.B. bei den Invertern I1 und I2 einerseits sowie bei den Invertern I3 und I4 andererseits sind die Sourceanschlüsse ihrer Transistoren vom anderen Kanaltyp miteinander verbunden. Sie bilden somit jeweils einen ersten Verbindungspunkt C,$\overline{C}$. Insgesamt entstehen also zwei erste Verbindungspunkte C und $\overline{C}$.

An jeden ersten Verbindungspunkt C,$\overline{C}$ ist außerdem jeweils ein erster Schalttransistor T1 bzw. $\overline{T1}$ vom anderen Kanaltyp mit seiner Drain angeschlossen. Somit enthält die erfindungsgemäße Dekodierschaltung nach Fig. 1 insgesamt zwei erste Schalttransistoren T1 und $\overline{T1}$. Deren Sourceanschlüsse wiederum sind ebenfalls miteinander verbunden. Sie bilden einen letzten Verbindungspunkt A.

An diesem ist ein letzter Schalttransistor TO vom anderen Kanaltyp mit seiner Drain angeschlossen. Die Source dieses letzten Schalttransistors TO ist mit einem zweiten Versorgungspotential VSS verbunden und sein Gate mit dem einzelnen Eingangssignal AO. Das zweite Versorgungspotential VSS kann typischerweise das übliche Bezugspotential Masse sein.

Je erstem Verbindungspunkt C,$\overline{C}$ sind die Gates beider Transistoren eines (I1 bzw. I3) der beiden an ihm angeschlossen CMOS-Inverter I1,I2 bzw. I3,I4 mit einem ersten (An) der vier weiteren paarweise zueinander komplementären Eingangssignale A1,An,$\overline{A1}$,$\overline{An}$ verbunden. Entsprechend sind je erstem Verbindungspunkt C,$\overline{C}$ die Gates beider Transistoren des anderen (I2 bzw. I4) der beiden an den ersten Verbindungspunkt C,$\overline{C}$ angeschlossenen CMOS-Inverter I1,I2 bzw. I3,I4 mit dem zu dem ersten (An) der weiteren vier paarweise zueinander komplementären Eingangssignale A1,An, $\overline{A1}$, $\overline{An}$ komplementären Eingangssignal $\overline{An}$ verbunden. Dadurch sind im Betrieb bei den Invertern I1 und I3 in Abhängigkeit vom Zustand des angeschlossenen ersten weiteren Eingangssignales An gleichzeitig entweder die Transistoren vom einen Kanaltyp oder die vom anderen Kanaltyp durchgesteuert. Entsprechendes Verhalten weisen die Inverter I2 und I4 auf, wobei deren Schaltverhalten gleichzeitig aufgrund ihres zum ersten weiteren Eingangssignal An komplementären Eingangssignals $\overline{An}$ insgesamt komplementär ist zu dem der Inverter I1 und I3.

Das Gate eines (TI) der beiden mit dem letzten Verbindungspunkt A verbundenen ersten Schalttransistoren T1,$\overline{T1}$ ist mit einem zweiten (AI) der vier weiteren paarweise zueinander komplementären Eingangssignale A1,An,$\overline{A1}$,$\overline{An}$ verbunden. Entsprechend ist das Gate des anderen ($\overline{T1}$) der beiden mit dem letzten Verbindungspunkt A verbundenen ersten Schalttransistoren T1,$\overline{T1}$ mit dem zum zweiten (A1) der vier weiteren paarweise zueinander komplementären Eingangssignale A1,An,$\overline{A1}$,$\overline{An}$ komplementären Eingangssignal $\overline{A1}$ verbunden.

An jeden aller Verbindungspunkte A,C,$\overline{C}$ ist außerdem jeweils ein Komplementär-Transistor MO,M1,$\overline{M1}$ vom einen Kanaltyp mit seiner Drain angeschlossen. Die Source jedes Komplementär-Transistors MO,M1,$\overline{M1}$ ist mit dem ersten Versorgungspotential VCC verbunden. Das Gate jedes Komplementär-Transistors MO,M1,$\overline{M1}$ ist mit dem Gate desjenigen Schalttransistors TO,T1,$\overline{T1}$ verbunden, dessen Drain ebenfalls mit dem jeweiligen Verbindungspunkt A,$\overline{C}$,C und somit mit der Drain des Komplementär-Transistors MO,M1,$\overline{M1}$ verbunden ist.

Im folgenden wird die Funktion der Schaltung nach Figur 1 in Verbindung mit dem zugehörigen Zeitdiagramm nach Fig.2 anhand folgender Rahmenbedingungen erklärt: Das erste Versorgungspotential VCC beträgt 5 V. Das zweite Versorgungspotential VSS beträgt O V (Masse). Die Eingangssignale AO,A1,An,$\overline{A1}$,$\overline{An}$ weisen als ersten Pegel H auch ca. 5 V auf, als zweiten Pegel L ca. O V. Entsprechende Pegel nehmen auch die Dekoderausgänge DA1 bis DA4 an. Die vorstehenden Werte dienen nur als Beispiel. Andere Werte sind, wie bekannt, in CMOS-Technologie denkbar. Weiter sei angenommen, daß innerhalb einer betrachteten Taktperiode TP ab einem ersten Zeitpunkt tl das einzelne Eingangssignal AO und das erste (An) der vier weiteren, paarweise zueinander komplementären Eingangssignale A1,An,$\overline{A1}$,$\overline{An}$ den ersten logischen Pegel H aufweisen und das zweite (AI) der vier weiteren Eingangssi-

gnale A1,An,$\overline{A1}$,$\overline{An}$ den zweiten logischen Pegel L. Demzufolge weist ab dem Zeitpunkt tl das zum ersten (An) der vier weiteren Eingangssignale A1,An,$\overline{A1}$,$\overline{An}$ komplementäre Eingangssignal $\overline{An}$ den zweiten logischen Pegel L auf und das zum zweiten (A1) der vier weiteren Eingangssignale A1,An,$\overline{A1}$,$\overline{An}$ komplementäre Eingangssignal $\overline{A1}$ den ersten logischen Pegel H.

Unter den vorstehenden Randbedingungen weisen das einzelne Eingangssignal AO, das erste (An) und das zweite (Al) der vier weiteren, paarweise zueinander komplementären Eingangssignale A1,An,$\overline{A1}$,$\overline{An}$ vom Beginn der Taktperiode TP bis zum Zeitpunkt tl den zweiten logischen Pegel L auf. Entsprechend weisen die zu dem ersten und zweiten (An,Al) der vier weiteren Eingangssignale komplementären Eingangssignale $\overline{An}$,$\overline{A1}$ vom Beginn der Taktperiode TP bis zum Zeitpunkt tl den ersten logischen Pegel H auf. Bei dieser Kombination der Eingangssignale AO,Al,An,$\overline{A1}$ und $\overline{An}$ im Zeitraum vom Beginn der Taktperiode TP bis zum Zeitpunkt tl weisen alle Dekoderausgänge DA1 bis DA4 den ersten logischen Pegel H auf.

Die Dekoderausgänge DA1 und DA3 sind deshalb auf dem ersten logischen Pegel H, weil der dem jeweiligen CMOS-Inverter I1,I3 angehörige Transistor vom einen Kanaltyp zum ersten Versorgungspotential VCC durchgeschaltet ist. Der Dekoderausgang DA2 ist deshalb auf dem ersten logischen Pegel H, weil der dem zugehörigen CMOS-Inverter I2 angehörige Transistor vom anderen Kanaltyp zum ersten Verbindungspunkt C durchgeschaltet ist. Dieser weist jedoch wegen des Durchschaltens des ihm zugeordneten Komplementär-Transistors M1 den ersten logischen Pegel H auf. Entsprechend weist der Dekoderausgang DA4 den ersten logischen Pegel H auf, weil einerseits der dem zugehörigen CMOS-Inverter I4 angehörige Transistor vom anderen Kanaltyp zum ersten Verbindungspunkt $\overline{C}$ durchgeschaltet ist und andererseits der erste Schalttransistor $\overline{T1}$ zum letzten Verbindungspunkt A durchgeschaltet ist. Dieser weist jedoch wegen des durchgeschalteten Komplementär-Transistors MO den ersten logischen Pegel H auf.

Ab dem Zeitpunkt tl nehmen die Eingangssignale AO,A1,An,$\overline{A1}$,$\overline{An}$ den logischen Pegel an, der der Information (typischerweise ist dies eine Adreßinformation) entspricht, die sie darstellen sollen. Im vorliegenden Beispiel nehmen also das einzelne Eingangssignal AO, das erste weitere Eingangssignal An und das zum zweiten weiteren Eingangssignal Al komplementäre Eingangssignal $\overline{A1}$ den ersten logischen Pegel H an bzw. behalten diesen Pegel bei. Entsprechend nehmen das zum ersten weiteren Eingangssignal An komplementäre Eingangssignal $\overline{An}$ und das zweite weitere Eingangssignal Al den zweiten logischen Pegel L an bzw. behalten ihn bei. Der letzte Verbindungspunkt A nimmt somit den zweiten logischen Pegel L an, da der letzte Schalttransistor TO durchgeschaltet ist und der ihm zugeordnete Keep-Up-Transistor MO sperrt. An den Sourceanschlüssen der ersten Schalttransistoren T1,$\overline{T1}$ liegt somit der zweite logische Pegel L an.

Der erste Schalttransistor Tl ist gesperrt, der zugeordnete Komplementär-Transistor Ml jedoch leitend. Entsprechend weist der erste Verbindungspunkt C den ersten logischen Pegel H auf. Da beim ersten CMOS-Inverter I1 der Transistor vom anderen Kanaltyp leitet, wird der erste logische Pegel H des ersten Verbindungspunktes C über diesen Transistor zum ersten Dekoderausgang DA1 durchgeschaltet. Beim zweiten Dekoderausgang DA2 ist beim zugehörigen CMOS-Inverter I2 der Transistor vom einen Kanaltyp leitend; der zweite Dekoderausgang DA2 weist ebenfalls den ersten logischen Pegel H auf.

Der erste Schalttransistor $\overline{T1}$ ist durchgeschaltet, sein zugeordneter Komplementär-Transistor $\overline{M1}$ sperrt. Damit liegt am ersten Verbindungspunkt $\overline{C}$ der zweite logische Pegel L an. Da beim dritten CMOS-Inverter I3, dem der dritte Dekoderausgang DA3 zugeordnet ist, der Transistor vom anderen Typ leitet, wird der am ersten Verbindungspunkt $\overline{C}$ anliegende zweite logische Pegel L an den Dekoderausgang DA3 durchgeschaltet. Dieser ist damit ausgewählt.

Der vierte Dekoderausgang DA4 bleibt über den durchgeschalteten Transistor vom einen Kanaltyp des zugeordneten vierten CMOS-Inverters I4 auf dem ersten logischen Pegel H.

Ab einem späteren Zeitpunkt t2 nehmen die Eingangssignale AO,A1,An,$\overline{A1}$,$\overline{An}$ wieder ihre ursprünglichen Pegel ein, wie sie sie vom Beginn der Taktperiode TP bis zum ersten Zeitpunkt tl aufweisen. Infolgedessen nehmen, wie vorstehend bereits für den Zeitraum bis zum ersten Zeitpunkt tl beschrieben, die Dekoderausgänge DA1 bis DA4 ihren ersten logischen Pegel H an bzw. behalten diesen bei.

Mit dem am ausgewählten Dekoderausgang DA3 auftretenden Ausgangssignal kann beispielsweise eine andere, nachgeschaltete Dekodierschaltung eingangsmäßig beschaltet werden, unabhängig davon, ob die nachgeschaltete Dekodierschaltung von der erfindungsgemäßen Art ist oder nach dem Stande der Technik. Dann wirkt die erfindungsgemäße Dekodierschaltung wie ein Vordekodierer. Jeder Dekoderausgang DA1 bis DA4 spricht also indirekt eine Gruppe von Wort- oder Bitleitungen an, falls die erfindungsgemäße Dekodierschaltung in einem Halbleiterspeicher integriert ist.

Das Ausgangssignal kann aber auch direkt auf eine anzusteuernde andere Schaltung oder Steuerleitung, z.B. eine Wortleitung oder eine Bitleitung bei einem Halbleiterspeicher gegeben werden.

Eine solcherart gestaltete Dekodierschaltung vermeidet alle die vorgenannten Nachteile nach dem Stande der Technik. Neben einem minimierten Stromverbrauch zeichnet sich die erfindungsgemäße Dekodierschaltung durch jederzeit klar definierte Potentialzustände an den Verbindungspunkten A,C,$\overline{C}$ und damit auch an den Dekoderausgängen DA1 bis DA4 aus. Bei Verwendung in einem Halbleiterspeicher in der oben beschriebenen Art als Vordekodierer lassen sich mit den Dekoderausgängen DA1 bis DA4 zunächst Gruppen von Wort- oder Bitleitungen ansprechen, die durch der erfindungsgemäßen Dekodierschaltung nachgeschaltete Dekodierer in Verbindung mit sonstigen weiteren Adreßleitungen ein-

zeln angesprochen werden können. Die nachgeschalteten Dekodierer können dabei von der erfindungsgemäßen Art sein oder solche nach dem Stande der Technik. Auf diese Weise läßt sich bei der Realisierung einer Dekodierschaltung nach der erfindungsgemäßen Art, insbesondere bei deren Integration in einen integrierten Halbleiterschaltkreis u.a. sehr viel Platz sparen gegenüber einer Realisierung nach dem Stande der Technik.

Die der Erfindung zugrundeliegende Idee ist so allgemein ausführbar, daß sie nicht nur, wie vorstehend mit Hilfe der Figuren 1 und 2 beschrieben, auf insgesamt fünf Eingangssignale AO,A1,An,$\overline{A1}$,$\overline{An}$ und vier Dekoderausgänge DA1 bis DA4 anwendbar ist, sondern ganz allgemein auf Dekodierschaltungen mit 2n+1 Eingangssignale AO.... und $2^n$ Dekoderausgänge DA1... . Nachfolgend wird die erfindungsgemäße Dekodierschaltung anhand der Figuren 3 und 4 beschrieben für n=3 als weitere mögliche Ausführungsform. Notwendige Schaltungsmaßnahmen für n> 3 sind ebenfalls beschrieben, jedoch zeichnerisch aus Gründen der Übersichtlichkeit nicht dargestellt. Die erfindungsgemäße Schaltung nach Fig. 3 baut dabei auf die Ausführungsform gemäß Fig. 1 auf.

Diese Weiterbildung der erfindungsgemäßen Dekodierschaltung weist, verglichen mit der vorstehend beschriebenen Ausführung nach Figur 1 (mit n=2) Eingänge für weitere 2(n-2) Eingangssignale auf, die paarweise komplementär zueinander sind. Für n=3 ergeben sich also (vgl.Figur 3) zwei weitere, zueinander komplementäre Eingangssignale A2 und $\overline{A2}$. Weiters weist sie weitere $2^{n-1}$ Dekoderausgänge auf, entsprechend nach Figur 3 für n=3 weitere vier Dekoderausgänge DA5 bis DA8. Diese sind gleichzeitig Ausgänge für weitere $2^{n-1}$ CMOS-Inverter, z.B. I5 bis I8.

Analog zur Ausführung nach Figur 1 sind bei jeweils zwei (I5 und I6 bzw. I7 und I8) der weiteren CMOS-Inverter I5 bis I8 die Sourceanschlüsse ihrer Transistoren vom anderen Kanaltyp miteinander verbunden. Sie bilden jeweils einen weiteren ersten Verbindungspunkt D bzw. $\overline{D}$. Insgesamt entstehen somit $2^{n-1}$ erste Verbindungspunkt C,D,$\overline{C}$,$\overline{D}$. Die weiteren CMOS-Inverter I5 bis I8 sind ansonsten genauso verschaltet wie die ersten vier CMOS-Inverter I1 bis I4, d.h. insbesondere die Gates ihrer Transistoren sind, alternierend von CMOS-Inverter zu CMOS-Inverter, mit dem ersten weiteren Eingangssignal An und dem dazu komplementären Eingangssignal $\overline{An}$ verbunden.

In Abweichung zu der Ausgestaltung nach Figur 1 ist bei der erfindungsgemäßen Schaltung nach Figur 3 an jeden aller ersten Verbindungspunkte C,D,$\overline{C}$,$\overline{D}$ des weiteren ein erster Schalttransistor $T2_0$,$T2_1$,$\overline{T2_0}$,$\overline{T2_1}$,vom anderen Kanaltyp mit seiner Drain angeschlossen. Die Sourceanschlüsse von jeweils zwei ($T2_0$ und $\overline{T2_0}$ bzw. $T2_1$ und $\overline{T2_1}$) aller ersten Schalttransistoren $T2_0$,$T2_1$,$\overline{T2_0}$,$\overline{T2_1}$, sind zu einem zweiten Verbindungspunkt B bzw. $\overline{B}$ zusammengeschlossen. Dadurch werden insgesamt $2^{n-2}$ Verbindungspunkte B,$\overline{B}$ gebildet.

Für n> =3 ist an jeden der zweiten Verbindungspunkte B,$\overline{B}$ außerdem ein zweiter Schalttransistor $T1_0$,$\overline{T1_0}$ vom anderen Kanaltyp mit seiner Drain angeschlossen. Dieser Anschluß von zweiten Schalttransistoren an die zweiten Verbindungspunkte B,$\overline{B}$ erfolgt also in derselben Art und Weise wie der bereits beschriebene Anschluß von ersten Schalttransistoren mit ihren Drains an die ersten Verbindungspunkte. Entsprechend dazu sind auch die Sourceanschlüsse von jeweils zwei der zweiten Schalttransistoren $T1_0$,$\overline{T1_0}'$ miteinander verbunden. Sie bilden damit einen weiteren Verbindungspunkt. So entstehen insgesamt $2^{n-3}$ weitere Verbindungspunkte. Für n> =3 erfolgt diese Aneinanderreihung von Schalttransistoren unter Zusammenfasung der Sourceanschlüsse von jeweils zwei Schalttransistoren erfindungsgemäß auf hierarchischer Art (z.B. in Fig. 3 von oben nach unten) ab den ersten Verbindungspunkten C,D,$\overline{C}$,$\overline{D}$, in hierarchischen Stufen gezählt, in n-1 Schaltstufen. Am Ende dieser Aneinanderreihung entsteht somit als letzter der weiteren Verbindungspunkte der letzte Verbindungspunkt A. Damit entstehen auch zwischen den ersten Verbindungspunkten C,D,$\overline{C}$,$\overline{D}$ über die zweiten Verbindungspunkte B, $\overline{B}$ und die weiteren Verbindungspunkte bis zum letzten Verbindungspunkt A insgesamt n-1 Schaltstufen.

Gatemäßig sind die ersten ($T2_0$,$T2_1$,$\overline{T2_0}$,$\overline{T2_1}$), die zweiten ($T1_0$,$\overline{T1_0}$) und die weiteren Schalttransistoren folgendermaßen verschaltet: Bei jedem der zweiten Verbindungspunkte B bzw. $\overline{B}$ ist das Gate eines ($T2_0$ bzw. $T2_1$) der beiden mit dem zweiten Verbindungspunkt B bzw. $\overline{B}$ verbundenen ersten Schalttransistoren $T2_0$ und $\overline{T2_0}$ bzw. $T2_1$ und $\overline{T2_1}$ mit einem ersten (A2) der weiteren 2(n-2) paarweise zueinander komplementären Eingangssignale A2, $\overline{A2}$ verbunden. Entsprechend ist das Gate des anderen ($\overline{T2_0}$ bzw. $\overline{T2_1}$) der beiden mit dem zweiten Verbindungspunkt B bzw. $\overline{B}$ verbundenen ersten Schalttransistoren $T2_0$ und $\overline{T2_0}$ bzw. $T2_1$ und $\overline{T2_1}$ mit dem zum ersten (A2) der weiteren 2(n-2) paarweise zueinander komplementären Eingangssignale A2,$\overline{A2}$ komplementären Eingangssignal $\overline{A2}$ verbunden.

Für n>3 ist außerdem bei jeder Schaltstufe mit weiteren Schalttransistoren mit Ausnahme der Schaltstufe mit dem letzten Schalttransistor A für jeden der weiteren Verbindungspunkte einerseits das Gate eines der beiden mit dem jeweiligen weiteren Verbindungspunkt verbundenen weiteren Schalttransistoren mit einem weiteren der weiteren 2(n-2) paarweise zueinander komplementären Eingangssignale verbunden und andererseits das Gate des anderen der beiden mit den zum weiteren Verbindungspunkt verbundenen weiteren Schalttransistoren mit dem zum weiteren der weiteren 2(n-2) paarweise zueinander komplementären Eingangssignale komplementären Eingangssignal verbunden.

Entsprechend in Analogie zur Ausführungsform nach Fig. 1 ist nach Fig.3 bei der Schaltstufe mit dem letzten Schalttransistor A das Gate eines ($T1_0$) der beiden zweiten Schalttransistoren $T1_0$,$\overline{T1_0}$ mit dem zweiten (A1) der vier weiteren, paarweise zueinander komplementären Eingangssignale A1, An,$\overline{A1}$,$\overline{An}$ verbunden und das Gate des anderen ($\overline{T1_0}$) der zweiten Schalttransistoren $T1_0$,$\overline{T1_0}$ ist mit dem zum zweiten (A1) der vier weiteren, paarweise zueinander komplementären Eingangssignale A1,An,$\overline{A1}$,$\overline{An}$ komplementären Eingangssignal $\overline{A1}$ verbunden.

Gemäß dem allgemeinen Erfindungsprinzip, insbesondere gemäß dem Ausführungsbeispiel nach Figur 3 ist an jedem aller ersten Verbindungspunkte C,D,$\overline{C}$,$\overline{D}$ sowie an jedem aller zweiten (B,$\overline{B}$) und weiteren Verbindungspunkte außer den Schalttransistoren jeweils ein Komplementär-Transistor $M2_0$,$\overline{M2_1}$, $M2_0$,$M2_1$,$M1_0$,$\overline{M1}_0$ vom einen Kanaltyp mit seiner Drain angeschlossen. Die Sources jedes dieser Komplementär-Transistoren $M2_0$,$M2_1$,$\overline{M2}_0$,$\overline{M2}_1$,$M1_0$,$\overline{M1}_0$ sind jeweils mit dem ersten Versorgungspotential VCC verbunden. Ihr Gate ist jeweils mit dem Gate desjenigen Schalttransistors $T1_0$,$\overline{T1}_0$,$T2_0$,$T2_1$, $\overline{T2}_0$,$\overline{T2}_1$ verbunden, dessen Drain ebenfalls mit dem jeweiligen Verbindungspunkt, und damit mit der daran angeschlossenen Drain des Komplementär-Transistors $M1_0$,$\overline{M1}_0$,$M2_0$,$M2_1$, $\overline{M2}_0$,$\overline{M2}_1$ verbunden ist.

Die Funktion der Schaltung gemäß Figur 3 läßt sich beispielsweise mit Hilfe des Zeitdiagrammes nach Figur 4 folgendermaßen erklären: Die Eingangssignale AO,A1,An,$\overline{A1}$ und $\overline{An}$ weisen innerhalb der gesamten Taktperiode TP denselben Zeitverlauf auf wie bei der Schaltung gemäß Figur 1 und dem Taktdiagramm gemäß Figur 2. Das weitere Eingangssignal A2 weise vom Beginn der Taktperiode TP bis zum ersten Zeitpunkt tl den zweiten logischen Pegel L auf, das dazu komplementäre weitere Eingangssignal $\overline{A2}$ den ersten logischen Pegel H. Ab dem ersten Zeitpunkt tl bis zum späteren Zeitpunkt t2 weise das weitere Eingangssignal A2 den ersten logischen Pegel H auf, das dazu komplementäre weitere Eingangssignal $\overline{A2}$ den zweiten logischen Pegel L.

Vom Beginn der Taktperiode TP an bis zum ersten Zeitpunkt tl weisen alle Dekodierausgänge DA1 bis DA8 den ersten logischen Pegel H auf, weil einerseits das einzelne Eingangssignal AO, die weiteren Eingangssignale Al und An sowie das Eingangssignal A2 der weiteren 2(n-2) Eingangssignale ihren zweiten logischen Pegel L aufweisen und andererseits die zu den weiteren Eingangssignalen Al,A2 An komplementären Eingangssignale $\overline{A1}$,$\overline{A2}$,$\overline{An}$ den ersten logischen Pegel H aufweisen. Damit liegen sämtliche Verbindungspunkte A,B,C,D,$\overline{B}$,$\overline{C}$,$\overline{D}$ und somit auch sämtliche Dekoderausgänge DA1 bis DA8 auf dem ersten logischen Pegel H.

Ab dem ersten Zeitpunkt tl wechseln, wie bereits beschrieben, das einzelne Eingangssignal AO und das weitere Eingangssignal Al ihren logischen Pegel, ebenso das dazu komlementäre Eingangssignal $\overline{An}$. Außerdem nimmt das als Signal A2 der weiteren 2(n-2) Eingangssignale bezeichnete Signal den ersten logischen Pegel H an. Entsprechend nimmt das dazu komplementäre Eingangssignal $\overline{A2}$ den zweiten logischen Pegel L an.

Infolgedessen weist im Zeitraum zwischen tl und t2 der letzte Verbindungspunkt A den zweiten logischen Pegel L auf (letzter Schalttransistor TO ist durchgeschaltet).

Der eine (B) der beiden zweiten Verbindungspunkte B,$\overline{B}$ liegt über dem ihm zugeordneten Komplementär-Transistor $Ml_0$ auf dem ersten logischen Pegel H, da das diesen Komplementär-Transistor $Ml_0$ und den einen ($T1_0$) der beiden zweiten Schalttransistoren $T1_0$,$\overline{T1}_0$ steuernde, weitere Eingangssignal Al den zweiten logischen Pegel L aufweist. Entsprechend liegt der andere ($\overline{B}$) der beiden zweiten Verbindungspunkte B,$\overline{B}$ über den anderen ($\overline{T1}_0$) der beiden zweiten Schalttransistoren $T1_0$,$\overline{T1}_0$ auf dem logischen Pegel, der am letzten Verbindungspunkt A liegt, d.h. also auf dem zweiten logischen Pegel L. Durch das zum obengenannten weiteren Eingangssignal Al komplementäre Eingangssignal $\overline{A1}$ sind nämlich der andere ($\overline{T1}_0$) der beiden Schalttransistoren $T1_0$,$\overline{T1}_0$ leitend und der zugehörige Komplementär-Transistor $\overline{M1}_0$ gesperrt.

Das Eingangssignal A2 der weiteren 2(n-2) Eingangssignale A2,$\overline{A2}$ schaltet die ersten Schalttransistoren $T2_0$,$T2_1$ durch. Damit nehmen die ersten Verbindungspunkte C und D die logischen Pegel an, die die beiden zweiten Verbindungspunkte B,$\overline{B}$ aufweisen. Der erste Verbindungspunkt C liegt also auf dem ersten logischen Pegel H, der erste Verbindungspunkt D auf dem zweiten logischen Pegel L.

Gleichzeitig sperrt das zum Eingangssignal A2 der weiteren 2(n-2) Eingangssignale A2,$\overline{A2}$ komplementäre Eingangssignal $\overline{A2}$ die von ihm gesteuerten ersten Schalttransistoren $\overline{T2}_0$ und $\overline{T2}_1$. Entsprechend schaltet dieses komplementäre Eingangssignal $\overline{A2}$ die den ersten Schalttransistoren $\overline{T2}_0$,$\overline{T2}_1$ zugeordneten Komplementär-Transistoren $\overline{M2}_0$ und $\overline{M2}_1$ durch. Die ersten Verbindungspunkte $\overline{C}$ und $\overline{D}$ weisen somit den ersten logischen Pegel H auf.

Da die ersten Verbindungspunkte C,$\overline{C}$ und $\overline{D}$ den ersten logischen Pegel H aufweisen, können die Dekoderausgänge DA1 bis DA4, DA7 und DA8, unabhängig vom logischen Pegel der an den Eingängen der betreffenden CMOS-Inverter I1 bis I4, I7 und I8 anliegenden weiteren Eingangssignale An und $\overline{An}$, nur den ersten logischen Pegel H aufweisen.

Der Dekoderausgang DA6 bleibt ebenfalls auf dem ersten logischen Pegel H, da das am entsprechenden CMOS-Inverter I6 anliegende Eingangssignal $\overline{An}$ innerhalb dieses CMOS-Inverters I6 den Transistor vom einen Kanaltyp leitend schaltet. Dadurch gelangt das erste Versorgungspotential VCC als erster logischer Pegel H an den Dekoderausgang DA6.

Das am Eingang des CMOS-Inverters I5 anliegende weitere Eingangssignal An schaltet jedoch innerhalb dieses CMOS-Inverters I5 den Transistor vom anderen Kanaltyp durch, womit der am ersten Verbindungspunkt D anliegende zweite logische Pegel L auf den Dekoderausgang DA5 durchgeschaltet wird. Es wird also mittels der im Beispiel gewählten Information als Kombination von Eingangssignalwerten eindeutig, stabil und ausschließlich der Dekoderausgang DA5 ausgewählt, die restlichen Dekoderausgänge DA1 bis DA5 und DA6 bis DA8 bleiben nicht ausgewählt.

Ab dem späteren Zeitpunkt t2 bis zum Ende der Taktperiode TP weisen alle Eingangssignale wieder ihre Ursprungswerte auf, die sie vom Beginn der Taktperiode TP an bis zum ersten Zeitpunkt tl aufwiesen.

Es ist auch Bestandteil der vorliegenden Erfindung, daß die Transistoren vom einen Kanaltyp p-Kanal-Transistoren, insbesondere vom Enhancementtyp sind, daß die Transistoren vom anderen Kanaltyp n-Kanal-Transistoren, insbesondere vom Enhancementtyp sind und daß das erste Versorgungspotential VCC ein positiveres Potential ist als das zweite Versorgungspotential VSS.

Entsprechend ist auch eine umgekehrte Zuordnung möglich, bei der die Transistoren vom einen Kanaltyp n-Kanal-Transistoren sind, die vom anderen Kanaltyp p-Kanal-Transistoren sind und das erste Versorgungspotential VCC ein negativeres Potential ist als das zweite Versorgungspotential VSS. Vorteilhafterweise sind diese Transistoren ebenfalls vom Enhancementtyp.

Vorteilhafterweise weist eine erste Gruppe ($A0, A1, A2, An$) von allen Eingangssignalen ($A0, A1, A2, An, \overline{A1}, \overline{A2}, \overline{An}$) vom Beginn der Taktperiode TP bis zum ersten Zeitpunkt tl (inaktivierter Zustand) als logischen Pegel einen Wert auf, der im wesentlichen gleich dem zweiten Versorgungspotential VSS ist. Entsprechend weisen sie restlichen Eingangssignale $\overline{A1}, \overline{A2}, \overline{An}$ die ja komplementär zu entsprechenden Eingangssignalen der ersten Gruppe ($A0, A1, A2, An$) sind, in diesem Zeitraum einen logischen Pegel auf, der im wesentlichen gleich dem ersten Versorgungspotential VCC ist.

Ein wesentlicher Unterschied zwischen einer Dekodierschaltung nach dem Stande der Technik und den beschriebenen Ausführungsformen der erfindungsgemäßen Dekodierschaltung besteht darin, daß beim Stande der Technik ein ausgewählter Dekoderausgang den ersten logischen Pegel H beibehält und im nicht ausgewählten Zustand auf den zweiten logischen Pegel L durchgeschaltet wird. Bei den beschriebenen Ausführungsformen weist jedoch der Dekoderausgang, der ausgewählt ist, den zweiten logischen Pegel L auf und alle anderen, nicht ausgewählten Dekoderausgänge weisen den ersten logischen Pegel H auf. Dies hat jedoch auf die Ausgestaltung weiterer nachgeschalteter Schaltungsteile keinerlei negativen Einfluß. Eine Ausführungsform der erfindungsgemäßen Dekodierschaltung zu erstellen, bei der die Dekoderausgänge im ausgewählten Zustand den ersten log. Pegel H aufweisen und im nichtausgewählten Zustand den zweiten log. Pegel L (vgl. Dekoder nach dem Stande der Technik), liegt für einen Durchschnittsfachmann im Rahmen seines fachlichen Könnens.

## <u>Bezugszeichenliste</u>

| | |
|---|---|
| $A0, A1, A2, An, \overline{A1}, \overline{A2}, \overline{An}$ | Eingangssignale |
| DA1 bis DA8 | Dekoderausgänge |
| I1 bis I8 | CMOS-Inverter |
| VCC, VSS | Versorgungspotential |
| $A, B, C, D, \overline{B}, \overline{C}, \overline{D}$ | Verbindungspunkte |
| $T0, T1, \overline{T1}, T1_0, T2_0, T2_1, \overline{T1_0}, \overline{T2_0}, \overline{T2_1}$ | Schalttransistoren |
| $M0, M1, \overline{M1}, M1_0, \overline{M1_0}, M2_0, M2_1, \overline{M2_0}, \overline{M2_1}$ | Komplementärtransistoren |
| n | natürliche Zahl |

## Patentansprüche

1. Dekodierschaltung zum Dekodieren einer durch Eingangssignale dargestellten Information mit folgenden Merkmalen:

a) sie weist Eingänge für ein einzelnes Eingangssignal (A0) und vier weitere, paarweise zueinander komplementäre Eingangssignale ($A1, An, \overline{A1}, \overline{An}$) sowie vier Dekodierausgänge (DA1 bis DA4) auf,

b) sie ist in CMOS-Technologie aufgebaut,

c) sie enthält vier CMOS-Inverter (I1 bis I4),

d) jeder Dekoderausgang (DA1 bis DA4) ist gleichzeitig Ausgang eines der CMOS-Inverter (I1 bis I4),

e) bei jedem CMOS-Inverter (I1 bis I4) ist der Transistor vom einen Kanaltyp an seiner Source mit einem ersten Versorgungspotential (VCC) verbunden,

f) bei jeweils zwei (I1, I2; I3, I4) der vier CMOS-Inverter (I1 bis I4) sind die Sourceanschlüsse ihrer Transistoren vom anderen Kanaltyp miteinander verbunden unter Bildung eines ersten Verbindungspunkts ($C; \overline{C}$), wodurch sich insgesamt zwei erste Verbindungspunkte ($C, \overline{C}$) ergeben,

g) an jeden ersten Verbindungspunkt ($C, \overline{C}$) ist des weiteren jeweils ein erster Schalttransistor ($T1, \overline{T1}$) vom anderen Kanaltyp angeschlossen,

h) die Sourceanschlüsse der beiden ersten Schalttransistoren (T1,$\overline{\text{T1}}$) sind miteinander verbunden unter Bildung eines letzten Verbindungspunkts (A),

i) an dem letzten Verbindungspunkt (A) ist ein letzter Schalttransistor (T0) vom anderen Kanaltyp mit seiner Drain angeschlossen, dessen Source mit einem zweiten Versorgungspotential (VSS) verbunden ist und an dessen Gate das einzelne Eingangssignal (A0) liegt, zu dem keines der weiteren vier Eingangssignale (A1,An,$\overline{\text{A1}}$,$\overline{\text{An}}$) komplementär ist,

j) je erstem Verbindungspunkt (C;$\overline{\text{C}}$) sind

j1) die Gates beider Transistoren eines (I1; I3) der beiden an ihm angeschlossenen CMOS-Inverter (I1, I2; I3, I4) mit einem ersten (An) der vier weiteren paarweise zueinander komplementären Eingangssignale (A1,An,$\overline{\text{A1}}$,$\overline{\text{An}}$) verbunden und

j2) die Gates beider Transistoren des anderen (I2; I4) der beiden an den ersten Verbindungspunkt (C;$\overline{\text{C}}$) angeschlossenen CMOS-Inverter (I1, I2; I3, I4) sind mit dem zum ersten (An) der vier weiteren paarweise zueinander komplementären Eingangssignale (A1,An,$\overline{\text{A1}}$,$\overline{\text{An}}$) komplementären Eingangssignal ($\overline{\text{An}}$) verbunden,

k) beim letzten Verbindungspunkt (A) ist

k1) das Gate eines (T1) der beiden mit dem letzten Verbindungspunkt (A) verbundenen ersten Schalttransistors (T1,$\overline{\text{T1}}$) mit einem zweiten (A1) der vier weiteren, paarweise zueinander komplementären Eingangssignale (A1,An,$\overline{\text{A1}}$,$\overline{\text{An}}$) verbunden und

k2) das Gate des anderen ($\overline{\text{T1}}$) der beiden mit dem letzten Verbindungspunkt (A) verbundenen ersten Schalttransistors (T1,$\overline{\text{T1}}$) ist mit dem zum zweiten (A1) der vier weiteren paarweise zueinander komplementären Eingangssignale (A1,An,$\overline{\text{A1}}$,$\overline{\text{An}}$) komplementären Eingangssignal ($\overline{\text{A1}}$) verbunden,

l) an jedem aller Verbindungspunkte (A,C,$\overline{\text{C}}$) ist jeweils weiter ein Komplementär-Transistor (M0,M1,$\overline{\text{M1}}$) vom einen Kanaltyp mit seiner Drain angeschlossen, dessen Source mit dem ersten Versorgungspotential (VCC) verbunden ist und dessen Gate mit dem Gate desjenigen Schalttransistors (T0,T1,$\overline{\text{T1}}$) verbunden ist, dessen Drain ebenfalls mit dem jeweiligen Verbindungspunkt (A,C,$\overline{\text{C}}$) und damit mit der daran angeschlossenen Drain des Komplementär-Transistors (M0,M1,$\overline{\text{M1}}$) verbunden ist.

2. Integrierbare Dekodierschaltung nach Anspruch 1, **dadurch gekennzeichnet**, daß sie mit n>2 folgende weitere Merkmale aufweist:

a) Eingänge für weitere 2(n-2) paarweise zueinander komplementäre Eingangssignale (A2,$\overline{\text{A2}}$),

b) weitere $2^{n-1}$ Dekoderausgänge (DA5 bis DA8), die gleichzeitig Ausgänge weiterer $2^{n-1}$ CMOS-Inverter (I5 bis I8) sind,

c) bei jeweils zwei (I5, I6; I7,I8) der weiteren CMOS-Inverter (I5 bis I8) sind die Sourceanschlüsse ihrer Transistoren vom anderen Kanaltyp miteinander verbunden und bilden einen weiteren ersten Verbindungspunkt (D,$\overline{\text{D}}$), wodurch insgesamt $2^{n-1}$ erste Verbindungspunkte (C,D,$\overline{\text{C}}$,$\overline{\text{D}}$) entstehen,

d) die weiteren CMOS-Inverter (I5 bis I8) sind ansonsten genauso verschaltet wie die ersten vier CMOS-Inverter (I1 bis I4),

e) an jeden aller ersten Verbindungspunkte (C,D,$\overline{\text{C}}$,$\overline{\text{D}}$) ist des weiteren ein erster Schalttransistor (T2$_0$,T2$_1$,$\overline{\text{T2}_0}$,$\overline{\text{T2}_1}$) vom anderen Kanaltyp mit seiner Drain angeschlossen,

f) die Sourceanschlüsse von jeweils zwei aller ersten Schalttransistoren (T2$_0$,$\overline{\text{T2}_0}$; T2$_1$,$\overline{\text{T2}_1}$) sind zu einem zweiten Verbindungspunkt (B;$\overline{\text{B}}$) zusammengeschlossen, wodurch insgesamt $2^{n-2}$ zweite Verbindungspunkte (B,$\overline{\text{B}}$) entstehen,

g) an jeden der zweiten Verbindungspunkte (B,$\overline{\text{B}}$) ist des weiteren ein zweiter Schalttransistor (T1$_0$,$\overline{\text{T1}_0}$) vom anderen Kanaltyp mit seiner Drain angeschlossen im Sinne von Merkmal e), wobei im Sinne von Merkmal f) die Sourceanschlüsse von jeweils zwei der zweiten Schalttransistoren (T1$_0$,$\overline{\text{T1}_0}$) miteinander verbunden sind und einen weiteren Verbindungspunkt bilden, wodurch insgesamt $2^{n-3}$ weitere Verbindungspunkte entstehen,

h) eine solche Aneinanderreihung von Schalttransistoren unter Zusammenfassung der Sourceanschlüsse von jeweils zwei Schalttransistoren ist insgesamt, gezählt ab Merkmal e), n-1-mal durchgeführt, so daß am Ende dieser Aneinanderreihung als letzter der weiteren Verbindungspunkte der letzte Verbindungspunkt (A) entsteht, und wodurch zwischen den ersten Verbindungspunkten (C,D,$\overline{\text{C}}$,$\overline{\text{D}}$) über die zweiten Verbindungspunkte (B,$\overline{\text{B}}$) und die weiteren Verbindungspunkte bis zum letzten Verbindungspunkt (A) insgesamt n-1 Schaltstufen entstehen,

i) bei jedem der zweiten Verbindungspunkte (B;$\overline{\text{B}}$) ist

i1) das Gate eines (T2$_0$,T2$_1$) der beiden mit dem zweiten Verbindungspunkt (B;$\overline{\text{B}}$) verbundenen ersten Schalttransistoren (T2$_0$;$\overline{\text{T2}_0}$; T2$_1$,$\overline{\text{T2}_1}$) mit einem ersten (A2) der weiteren 2(n-2) paarweise zueinander komplementären Eingangssignale (A2,$\overline{\text{A2}}$) verbunden und

i2) das Gate des anderen ($\overline{\text{T2}_0}$;$\overline{\text{T2}_1}$) der beiden mit dem zweiten Verbindungspunkt (B;$\overline{\text{B}}$) verbundenen ersten Schalttransistoren (T2$_0$,$\overline{\text{T2}_0}$;T2$_1$,$\overline{\text{T2}_1}$) mit dem zum ersten (A2) der weiteren 2(n-2) paarweise zueinander komplementären Eingangssignale (A2,$\overline{\text{A2}}$) komplementären Eingangssignal ($\overline{\text{A2}}$) verbunden,

j) bei jeder Schaltstufe mit weiteren Schalttransistoren mit Ausnahme der Schaltstufe mit dem letzten Schalttransistor (TO) ist

j1) das Gate eines der beiden mit dem weiteren Verbindungspunkt verbundenen weiteren Schalttransistoren mit einem weiteren der weiteren 2(n-2) paarweise zueinander komplementären Eingangssignale (A2,$\overline{\text{A2}}$) verbunden und

j2) das Gate des anderen der beiden mit dem weiteren Verbindungspunkt verbundenen weiteren Schalttransistoren ist mit dem zum weiteren der weiteren $2(n-2)$ paarweise zueinander komplementären Eingangssignale (A2, $\overline{A2}$) komplementären Eingangssignal verbunden,

k) an jedem aller ersten Verbindungspunkte (C,D,$\overline{C}$,$\overline{D}$) sowie an jedem aller zweiten (B,$\overline{B}$) und weiteren Verbindungspunkte ist außer den Schalttransistoren jeweils ein Komplementär-Transistor ($M2_0$,$M2_1$,$\overline{M2}_0$,$\overline{M2}_1$,$MI_0$,$\overline{MI}_0$) vom einen Kanaltyp mit seiner Drain angeschlossen, dessen Source ist mit dem ersten Versorgungspotential (VCC) verbunden und dessen Gate mit dem Gate desjenigen Schalttransistors ($T2_0$,$T2_1$,$\overline{T2}_0$,$\overline{T2}_1$,$TI_0$,$\overline{TI}_0$), dessen Drain ebenfalls mit dem jeweiligen Verbindungspunkt (C,D,$\overline{C}$,$\overline{D}$,B,$\overline{B}$) und damit mit der daran angeschlossenen Drain des Komplementär-Transistors ($M2_0$, $M2_1$,$\overline{M2}_0$, $\overline{M2}_1$,$MI_0$,$\overline{MI}_0$) verbunden ist.

3. Dekodierschaltung nach Anspruch 1 oder Anspruch 2,
**dadurch gekennzeichnet,**
daß die Transistoren vom einen Kanaltyp p-Kanal-Transistoren sind, daß die Transistoren vom anderen Kanaltyp n-Kanal-Transistoren sind und daß das erste Versorgungspotential (VCC) ein positiveres Potential ist als das zweite Versorgungspotential (VSS).

4. Dekodierschaltung nach Anspruch 1 oder Anspruch 2,
**dadurch gekennzeichnet,**
daß die Transistoren vom einen Kanaltyp n-Kanal-Transistoren sind, daß die Transistoren vom anderen Kanaltyp p-Kanal-Transistoren sind und daß das erste Versorgungspotential (VCC) ein negativeres Potential ist als das zweite Versorgungspotential (VSS).

5. Dekodierschaltung nach einem der vorhergehenden Ansprüche,
**dadurch gekennzeichnet,**
daß die Transistoren vom Enhancementtyp sind.

6. Dekodierschaltung nach einem der Ansprüche 1 bis 5,
**dadurch gekennzeichnet,**
daß diejenigen ($\overline{A1}$,$\overline{A2}$,$\overline{An}$) der weiteren Eingangssignale (A1,A2,An,$\overline{A1}$,$\overline{A2}$,$\overline{An}$), die zu den restlichen (A1,A2,An) der weiteren Eingangssignale (A1,A2,An,$\overline{A1}$,$\overline{A2}$,$\overline{An}$) komplementär sind, in einem nicht-aktivierten Zustand (bis tl) einen Potentialwert aufweisen, der im wesentlichen gleich dem ersten Versorgungspotential (VCC) ist und daß die restlichen (A1,A2,An) der weiteren Eingangssignale (A1,A2,An,$\overline{A1}$,$\overline{A2}$,$\overline{An}$) sowie das einzelne Eingangssignal (AO) im nicht-aktivierten Zustand (bis t1) einen Potentialwert aufweisen, der im wesentlichen gleich dem zweiten Versorgungspotential (VSS) ist.

7. Dekodierschaltung nach einem der Ansprüche 1 bis 5,
**dadurch gekennzeichnet,**
daß diejenigen ($\overline{A1}$,$\overline{A2}$,$\overline{An}$) der weiteren Eingangssignale (A1,A2,An,$\overline{A1}$,$\overline{A2}$,$\overline{An}$), die zu den restlichen (A1,A2,An) der weiteren Eingangssignale (A1,A2,An,$\overline{A1}$,$\overline{A2}$,$\overline{An}$) komplementär sind, in einem nicht-aktivierten Zustand (bis t1) einen Potentialwert aufweisen, der im wesentlichen gleich dem zweiten Versorgungspotential (VSS) ist und daß die restlichen (A1,A2,An) der weiteren Eingangssignale (A1,A2,An,$\overline{A1}$,$\overline{A2}$,$\overline{An}$) sowie das einzelne Eingangssignal (AO) im nicht-aktivierten Zustand (bis t1) einen Potentialwert aufweisen, der im wesentlichen gleich dem ersten Versorgungspotential (VCC) ist.

## Claims

1. Decoding circuit for decoding information represented by input signals having the following features:

a) it includes inputs for an individual input signal (A0), and four further input signals (A1,An,$\overline{A1}$,$\overline{An}$), which are complementary to each other in pairs, as well as four decoder outputs (DA1 to DA4),

b) it is constructed in CMOS technology,

c) it contains four CMOS inverters (I1 to I4),

d) each decoder output (DA1 to DA4) simultaneously forms the output of one of the CMOS inverters (I1 to I4),

e) in each CMOS inverter (I1 to I4), the source of the transistor of the one channel type is connected to a first supply potential (VCC),

f) in each of the two (I1, I2; I3, I4) of the four CMOS inverters (I1 to I4), the source terminals of their transistors of the other channel type are connected to each other, thereby forming a first connecting point (C;$\overline{C}$), as a result of which two first connecting points (C,$\overline{C}$) are generated overall,

g) a first switching transistor (T1, $\overline{T1}$) of the other channel type is connected to each first connecting point (C,$\overline{C}$),

h) the source terminals of the two first switching tranistors (T1,$\overline{T1}$) are connected to each other, thereby forming a last connecting point (A),

i) connected to the last connecting point (A) is the drain of a last switching transistor (T0) of the other channel type, the source of which is connected to a second supply potential (VSS), and connected to the gate thereof is the individual input signal (A0), to which none of the further four input signals (A1,An,$\overline{A1}$,$\overline{An}$) is complementary,

j) for each first connecting point (C;$\overline{C}$)

j1) the gates of both transistors of one (I1; I3) of the two CMOS inverters (I1, I2; I3, I4) connected

to it are connected to a first (An) of the four further input signals (A1,An,$\overline{A1}$,$\overline{An}$), which are complementary to each other in pairs, and

j2) the gates of both transistors of the other (I2; I4) of the two CMOS inverters (I1, I2; I3, I4) connected to the first connecting point (C;$\overline{C}$) are connected to the input signal ($\overline{An}$) which is complementary to the first (An) of the four further input signals (A1,An,$\overline{A1}$,$\overline{An}$), which are complementary to each other in pairs,

k) for the last connecting point (A)

k1) the gate of one (T1) of the two first switching transistors (T1,$\overline{T1}$) connected to the last connecting point (A) is connected to a second (A1) of the four further input signals (A1,An,$\overline{A1}$,$\overline{An}$), which are complementary to each other in pairs, and

k2) the gate of the other ($\overline{T1}$) of the two first switching transistors (T1,$\overline{T1}$) connected to the last connecting point (A) is connected to the input signal ($\overline{A1}$) complementary to the second (A1) of the four further input signals (A1,An,$\overline{A1}$,$\overline{An}$), which are complementary to each other in pairs,

l) the drain of a complementary transistor (M0,M1,$\overline{M1}$) of the one channel type is furthermore connected in each case to each of all connecting points (A,C,$\overline{C}$), the source of which is connected to the first supply potential (VCC), and the gate of which is connected to the gate of that switching transistor (T0,T1,$\overline{T1}$) whose drain is likewise connected to the respective connecting point (A,C,$\overline{C}$) and hence to the drain of the complementary transistor (M0,M1,$\overline{M1}$) connected thereto.

2. Integrable decoder circuit according to Claim 1, characterized in that it has the following additional features where n > 2:

a) inputs for further 2(n–2) input signals (A2,$\overline{A2}$), which are complementary to each other in pairs,

b) further $2^{n-1}$ decoder outputs (DA5 to DA8) which are simultaneously outputs of further $2^{n-1}$ CMOS inverters (I5 to I8),

c) for in each case two (I5, I6; I7, I8) of the further CMOS inverters (I5 to I8), the source terminals of their transistors of the other channel type are connected to each other and form a further first connecting point (D,$\overline{D}$), thereby generating a total of $2^{n-1}$ first connecting points (C,D,$\overline{C}$,$\overline{D}$),

d) the further CMOS inverters (I5 to I8) are otherwise wired exactly like the first four CMOS inverters (I1 to I4),

e) the drain of a first switching transistor (T2$_0$,T2$_1$,$\overline{T2_0}$,$\overline{T2_1}$) of the other channel type is furthermore connected to each one of the first connecting points (C,D,$\overline{C}$,$\overline{D}$),

f) the source terminals of in each case two of all first switching transistors (T2$_0$,$\overline{T2_0}$;T2$_1$,$\overline{T2_1}$) are combined to form a second connecting point (B;$\overline{B}$), thereby generating a total of $2^{n-2}$ second connecting points (B,$\overline{B}$),

g) the drain of a second switching transistor (T1$_0$,$\overline{T1_0}$) of the other channel type is furthermore connected to each of the second connecting points (B,$\overline{B}$) in the sense of feature e), and in the sense of feature f) the source terminals of in each case two of the second switching transistors (T1$_0$,$\overline{T1_0}$) are connected to each other and form a further connecting point, thereby generating a total of $2^{n-3}$ further connecting points,

h) such a concatenation of switching transistors, combining source terminals of in each case two switching transistors, is carried out, counting from feature e), a total of n–1 times, so that the last connecting point (A) is formed at the end of this concatenation as the last of the further connecting points, and thereby generating a total of n–1 switching stages between the first connecting points (C,D,$\overline{C}$,$\overline{D}$), via the second connecting points (B,$\overline{B}$) and the further connecting points up to the last connecting point (A),

i) for each of the second connecting points (B;$\overline{B}$)

i1) the gate of one (T2$_0$;T2$_1$) of the two first switching transistors (T2$_0$,$\overline{T2_0}$;T2$_1$,$\overline{T2_1}$) connected to the second connecting point (B;$\overline{B}$) is connected to a first (A2) of the further 2(n–2) input signals (A2,$\overline{A2}$) complementary to each other in pairs, and

i2) the gate of the other (T2$_0$;T2$_1$) of the two first switching transistors (T2$_0$,$\overline{T2_0}$;T2$_1$,$\overline{T2_1}$) connected to the second connecting point (B;$\overline{B}$) is connected to the input signal ($\overline{A2}$) complementary the first (A2) of the further 2(n–2) input signals (A2,$\overline{A2}$) complementary to each other in pairs,

j) for each switching stage with further switching transistors, except for the switching stage with the last switching transistor (T0),

j1) the gate of one of the two further switching transistors connected to the further connecting point is connected to a further one of the further 2(n–2) input signals (A2,$\overline{A2}$) complementary to each other in pairs, and

j2) the gate of the other of the two further switching transistors connected to the further connecting point is connected to the input signal complementary to the further one of the further 2(n–2) input signals (A2,$\overline{A2}$) complementary to each other in pairs,

k) the drain of a complementary transistor (M2$_0$,M2$_1$,$\overline{M2_0}$, $\overline{M2_1}$,M1$_0$,$\overline{M1_0}$) of the one channel type is connected in each case to each of first connecting points (C,D,$\overline{C}$,$\overline{D}$) and to each of the second (B,$\overline{B}$) and further connecting points, excepting the switching transistors, the source of which complementary transistor is connected to the first supply potential (VCC), and the gate of which is connected to the gate of that switching transistor (T2$_0$,T2$_1$,$\overline{T2_0}$,$\overline{T2_1}$,T1$_0$,$\overline{T1_0}$), the drain of which is likewise connected to the respective connecting point (C,$\overline{C}$,$\overline{D}$,B,$\overline{B}$) and therefore to the drain of the complementary

transistor ($M2_0$, $M2_1$, $\overline{M2_0}$, $\overline{M2_1}$, $M1_0$, $\overline{M1_0}$) connected thereto.

3. Decoding circuit according to Claim 1 or Claim 2, characterized in that the transistors of the one channel type are p-channel transistors, in that the transistors of the other channel type are n-channel transistors, and in that the first supply potential (VCC) is a potential more positive than the second supply potential (VSS).

4. Decoding circuit according to Claim 1 or Claim 2, characterized in that the transistors of the one channel type are n-channel transistors, in that the transistors of the other channel type are p-channel transistors, and in that the first supply potential (VCC) is a potential more negative than the second supply potential (VSS).

5. Decoding circuit according to one of the preceding claims, characterized in that the transistors are of the enhancement type.

6. Decoding circuit according to one of Claims 1 to 5, characterized in that those signals ($\overline{A1}$, $\overline{A2}$, $\overline{An}$) of the further input signals (A1,A2,An,$\overline{A1}$,$\overline{A2}$,$\overline{An}$) which are complementary to the remaining ones (A1,A2,An) of the further input signals (A1,A2,An,$\overline{A1}$,$\overline{A2}$,$\overline{An}$) have a potential value substantially equal to the first supply potential (VCC) in an inactive state (until t1), and in that the remaining ones (A1,A2,An) of the further input signals (A1,A2,An,$\overline{A1}$,$\overline{A2}$,$\overline{An}$) as well as the individual input signal (A0) have a potential value substantially equal to the second supply potential (VSS) in an inactive state (until t1).

7. Decoding circuit according to one of Claims 1 to 5, characterized in that those signals ($\overline{A1}$,$\overline{A2}$,$\overline{An}$) of the further input signals (A1,A2,An,$\overline{A1}$,$\overline{A2}$,$\overline{An}$) which are complementary to the remaining ones (A1,A2, An) of the further input signals (A1,A2,An,$\overline{A1}$,$\overline{A2}$,$\overline{An}$) have a potential value substantially equal to the second supply potential (VSS) in an inactive state (until t1), and in that the remaining ones (A1,A2,An) of the further input signals (A1,A2,An,$\overline{A1}$,$\overline{A2}$,$\overline{An}$) as well as the individual input signal (A0) have a potential value substantially equal to the first supply potential (VCC) in an inactive state (until t1).

## Revendications

1. Circuit décodeur servant à décoder une information représentée par des signaux d'entrée, présentant les caractéristiques suivantes:

a) il possède des entrées pour un signal individuel d'entrée (A0) et pour quatre autres signaux d'entrée complémentaires les uns des autres par couples (A1,An,$\overline{A1}$,$\overline{An}$), ainsi que quatre sorties (DA1 à DA4),

b) il est réalisé selon la technologie CMOS,

c) il contient quatre inverseurs CMOS (I1 à I4),

d) chaque sortie (DA1 à DA4) du décodeur constitue simultanément la sortie de l'un des inverseurs CMOS (I1 à I4),

e) pour chaque inverseur CMOS (I1 à I4), le transistor possédant un type de canal est raccordé par sa source à un premier potentiel d'alimentation (VCC),

f) pour respectivement deux (I1, I2; I3, I4) des quatre inverseurs CMOS (I1 à I4), les bornes de source des transistors possédant l'autre type de canal sont reliés entre elles en formant un premier point de jonction (C;$\overline{C}$), ce qui permet d'obtenir au total deux premiers points de jonction ($\overline{C}$,C),

g) d'autre part, respectivement un premier transistor de commutation (T1,$\overline{T1}$) possédant l'autre type de canal est raccordé à chaque premier point de jonction (C,$\overline{C}$),

h) les bornes de source des deux premiers transistors de commutation (T1,$\overline{T1}$) sont reliées entre elles moyennant la formation d'un dernier point de jonction (A),

i) au dernier point de jonction (A) est raccordé le drain d'un dernier transistor de commutation (T0) possédant l'autre type de canal, dont la source est reliée à un second potentiel d'alimentation (VSS) et à la grille duquel est appliqué le signal individuel d'entrée (A0), dont aucun des quatre autres signaux d'entrée (A1,An,$\overline{A1}$,$\overline{An}$) n'est complémentaire,

j) au niveau de chaque premier point de jonction (C;$\overline{C}$)

j1) les grilles des deux transistors de l'un (I1; I3) des deux inverseurs CMOS (I1, I2; I3, I4) raccordés à ce point de jonction sont chargés par un premier (An) des quatre autres signaux d'entrée complémentaires les uns des autres par couples (A1,An, $\overline{A1}$,$\overline{An}$), et

j2) les grilles des deux transistors de l'autre (I2; I4) des deux inverseurs CMOS (I1, I2; I3, I4) raccordés au premier point de jonction (C;$\overline{C}$), sont chargées par le signal d'entrée ($\overline{An}$) complémentaire du premier (An) des quatre autres signaux d'entrée complémentaires les uns des autres par couples (A1,An, $\overline{A1}$,$\overline{An}$),

k) au niveau du dernier point de jonction (A),

k1) la grille de l'un (T1) des deux premiers transistors de commutation (T1 $\overline{T1}$) reliés au dernier point de jonction (A) est chargée par un second (A1) des quatre autres signaux d'entrée complémentaires les uns des autres par couples (A1,An, $\overline{A1}$,$\overline{An}$), et

k2) la grille de l'autre ($\overline{T1}$) des deux premiers transistors de commutation (T1,$\overline{T1}$) reliés au dernier point de jonction (A) est chargée par le signal d'entrée ($\overline{A1}$) complémentaire du second (A1) des quatre autres signaux d'entrée complémentaires les uns des autres par couples (A1,An,$\overline{A1}$,$\overline{An}$),

l) à chacun de tous les points de jonction (A,C,$\overline{C}$) est raccordé respectivement le drain d'un transistor complémentaire (M0,M1,$\overline{M1}$) possédant un type de canal, dont la source est placée au premier potentiel d'alimentation (VCC) et dont la grille est raccordée à la grille du transistor de commutation $(T0,T1,\overline{T1})$, dont le drain est également relié au point de jonction respectif $(A,C,\overline{C})$ et par conséquent au drain, qui y est raccordé, du transistor complémentaire $(M0,M1,\overline{M1})$.

2. Circuit décodeur intégrable suivant la revendication 1, remarquable par les caractéristiques supplémentaires; avec $n > 2$:

a) des entrées pour $2(n-2)$ autres signaux d'entrée $(A2,\overline{A2})$ complémentaires les uns des autres par couples,

b) $2^{n-1}$ autres sorties (DA5 à DA8), qui constituent simultanément les sorties de $2^{n-1}$ autres inverseurs CMOS (I5 à I8),

c) pour respectivement deux (I5, I6; I7, I8) des autres inverseurs CMOS (I5 à I8), les bornes de source des transistors possédant l'autre type de canal sont reliées entre elles et forment un autre premier point de jonction $(D, \overline{D})$, ce qui fournit au total $2^{n-1}$ premiers points de jonction $(C,D,\overline{C},\overline{D})$,

d) les autres inverseurs CMOS (I5 à I8) sont par ailleurs raccordés exactement de la même manière que les quatre premiers inverseurs CMOS (I1 à I4),

e) d'autre part, le drain d'un premier transistor de commutation $(T2_0,T2_1,\overline{T2_0},\overline{T2_1})$ possédant l'autre type de canal est raccordé à chaque point de l'ensemble des premiers points de jonction $(C,D,\overline{C},\overline{D})$,

f) les bornes de source de respectivement deux de l'ensemble des premiers transistors de commutation $(T2_0,\overline{T2_0};T2_1,\overline{T2_1})$ sont interconnectées à un second point de jonction $(B; \overline{B})$, ce qui fait apparaître au total $2^{n-2}$ seconds points de jonction $(B,\overline{B})$,

g) d'autre part, le drain d'un second transistor de commutation $(T1_0,\overline{T1_0})$ possédant l'autre type de canal est raccordé à chacun des seconds points de jonction $(B,\overline{B})$ au sens de la caractéristique e), auquel cas les bornes de source de respectivement deux des seconds transistors de commutation $(T1_0,\overline{T1_0})$ sont reliées entre elles au sens de la caractéristique f) et forment un autre point de jonction, ce qui fait apparaître au total $2^{n-3}$ autres points de jonction,

h) un tel branchement en série de transistors de commutation avec interconnexion des bornes de source de respectivement deux transistors de commutation est exécuté au total $n-1$ fois, à partir de la caractéristique e) de sorte qu'à la fin de ce branchement en série, on obtient en tant que dernier des autres points de jonction, le dernier point de jonction (A), et qu'il apparaît au total $n-1$ étages de commutation entre les premiers points de jonction $(C,D,\overline{C},\overline{D})$ par l'intermédiaire des seconds points de jonction $(B, \overline{B})$ et des autres points de jonction, jusqu'au dernier point de jonction (A), i) pour chacun des seconds points de jonction $(B;\overline{B})$,

i1) la grille de l'un $(T2_0;T2_1)$ des deux premiers transistors de commutation $(T2_0,\overline{T2_0};T2_1,\overline{T2_1})$ reliés au second point de jonction (B;B) est chargée par un premier (A2) des $2(n-2)$ autres signaux d'entrée complémentaires les uns des autres par couples $(A2,\overline{A2})$, et

i2) la grille de l'autre $(\overline{T2_0};\overline{T2_1})$ des deux premiers transistors de commutation $(T2_0,\overline{T2_0};T2_1,\overline{T2_1})$ reliés au second point de jonction $(B;\overline{B})$ est chargée par le signal d'entrée $(\overline{A2})$ complémentaire du premier (A2) des $2(n-2)$ autres signaux d'entrée complémentaires les uns des autres par couples $(A2,\overline{A2})$,

j) dans chaque étage de commutation comportant d'autres transistors de commutation, à l'exception de l'étage de commutation comportant le dernier transistor de commutation (T0),

j1) la grille de l'un des deux autres transistors de commutation reliés à l'autre point de jonction est chargée par un autre signal faisant partie des $2(n-2)$ autres signaux d'entrée complémentaires les uns des autres par couples $(A2,\overline{A2})$, et

j2) la grille de l'autre des deux autres transistors de commutation reliés à l'autre point de jonction est chargée par le signal d'entrée complémentaire de l'autre signal faisant partie des $2(n-2)$ autres signaux d'entrée complémentaires les uns des autres par couples $(A2,\overline{A2})$,

k) à chacun de l'ensemble des premiers points de jonction $(C,D,\overline{C},\overline{D})$ ainsi qu'à chacun de l'ensemble des seconds points de jonction $(B,\overline{B})$ et des autres points de jonction est raccordé, en dehors des transistors de commutation, le drain d'un transistor complémentaire respectif $(M2_0,M2_1,\overline{M2_0},\overline{M2_1},M1_0,\overline{M1_0})$ possédant un premier type de canal, dont la source est reliée au premier potentiel d'alimentation (VCC) et dont la grille est raccordée à la grille du transistor de commutation $(T2_0,T2_1,\overline{T2_0},\overline{T2_1},T1_0,\overline{T1_0})$, dont le drain est également relié au point de jonction respectif $(C,D,\overline{C},\overline{D},B,\overline{B})$ et, par conséquent, au drain, qui y est raccordé, des transistors complémentaires $(M2_0,M2_1,\overline{M2_0},\overline{M2_1},M1_0,\overline{M1_0})$.

3. Circuit décodeur suivant la revendication 1 ou 2, caractérisé par le fait que les transistors possédant un premier type de canal sont des transistors à canal p, que les transistors possédant l'autre type de canal sont des transistors à canal n et que le premier potentiel d'alimentation (VCC) est un potentiel plus positif que le second potentiel d'alimentation (VSS).

4. Circuit décodeur suivant la revendication 1 ou la revendication 2, caractérisé par le fait que les transistors possédant un premier type de canal sont des transistors à canal n, que les transistors possédant l'autre type de canal sont des transistors à canal p et que le premier potentiel d'alimentation (VCC) possède un potentiel plus négatif que le second potentiel d'alimentation (VSS).

5. Circuit décodeur suivant l'une des revendications précédentes, caractérisé par le fait que les transistors sont du type à enrichissement.

6. Circuit décodeur suivant l'une des revendications 1 à 5, caractérisé par le fait que les signaux ($\overline{A1}$,$\overline{A2}$,$\overline{An}$) faisant partie des autres signaux d'entrée (A1,A2,An, $\overline{A1}$,$\overline{A2}$,$\overline{An}$), qui sont complémentaires des signaux restants (A1,A2,An), des autres signaux d'entrée (A1,A2,An, $\overline{A1}$,$\overline{A2}$,$\overline{An}$), possèdent, à l'état non activé (jusqu'à t1), une valeur de potentiel qui est sensiblement égale au premier potentiel d'alimentation (VCC), et que les signaux restants (A1,A2,An) parmi les autres signaux d'entrée (A1,A2,An, $\overline{A1}$,$\overline{A2}$,$\overline{An}$) ainsi que le signal individuel d'entrée (A0) possèdent, à l'état non activé (jusqu'à t1), une valeur de potentiel qui est sensiblement égale au second potentiel d'alimentation (VSS).

7. Circuit décodeur suivant l'une des revendications 1 à 5, caractérisé par le fait que les signaux ($\overline{A1}$,$\overline{A2}$,$\overline{An}$), faisant partie des autres signaux d'entrée (A1,A2,An,$\overline{A1}$,$\overline{A2}$,$\overline{An}$), qui sont complémentaires des signaux restants (A1,A2,An) parmi les autres signaux d'entrée (A1,A2,An, $\overline{A1}$,$\overline{A2}$,$\overline{An}$), possèdent, à l'état non activé (jusqu'à t1), une valeur de potentiel qui est sensiblement égale au premier potentiel d'alimentation (VSS), et que les signaux restants (A1,A2,An) parmi les autres signaux d'entrée (A1,A2,An, $\overline{A1}$,$\overline{A2}$,$\overline{An}$) ainsi que le signal individuel d'entrée (A0) possèdent, à l'état non activé (jusqu'à t1), une valeur de potentiel qui est sensiblement égale au second potentiel d'alimentation (VCC).

# FIG 1

# FIG 2

# FIG 3

EP 0 217 104 B1

# FIG 4